# EUROPEAN PATENT APPLICATION

(11) **EP 0 714 174 A2**
(43) Date of publication of application: **29.05.1996**
(21) Application number: 95118308.6
(22) Date of filing: 21.11.1995
(51) Int. Cl.: H04B 1/10, H04B 1/28

(54) **Front-end circuit for receiver with gain control circuit**

(30) Priority: 22.11.1994 JP 287729/94
(71) Applicant: NEC CORPORATION, Tokyo (JP)
(72) Inventor: Takano, Isamu, Yamagata-shi, Yamagata (JP)
(74) Representative: Glawe, Delfs, Moll & Partner

(57) **Abstract**

The receiver front-end circuit disclosed is one which has, on a single semiconductor chip, a radio frequency amplifier circuit (11A) and an intermediate frequency amplifier circuit (13A), and in which either the radio frequency amplifier circuit or the intermediate frequency amplifier circuit is gain-controlled in response to a gain control signal. The receiver front-end circuit includes a low-pass filter (15), a peak level detection circuit (16) and a gain control circuit (17). The low-pass filter (15) filters an intermediate output signal supplied by the intermediate frequency amplifier circuit and extracts a distorted signal corresponding to an intermodulation distortion component contained in the intermediate frequency signal. The peak level detection circuit (16) detects and generates a peak level of the distorted signal. The gain control circuit (17) generates the gain control signal in response to a supply of the peak level signal. The intermodulation distortion characteristics of the output IF signals have been improved in the receiver front-end circuit constituted by ICs.

## Description

### BACKGROUND OF THE INVENTION

### (1) Field of the Invention

The present invention relates to a front-end circuit for a receiver, and more particularly to a front-end circuit for a receiver for such as a mobile communication device fabricated by integrated circuits.

### (2) Description of the Related Art

Recently the market for mobile communication devices such as portable telephone devices is expanding, and importance is being placed on the characteristics of the intermodulation (IM) distortions generated by the inputting of a plurality of signals whose frequencies are different from each other because of non-linear characteristics of a high frequency or intermediate frequency amplifier, a mixer, etc. that constitute a front-end circuit of a receiver. This is also important from the aspect of securing the multi-channel property.

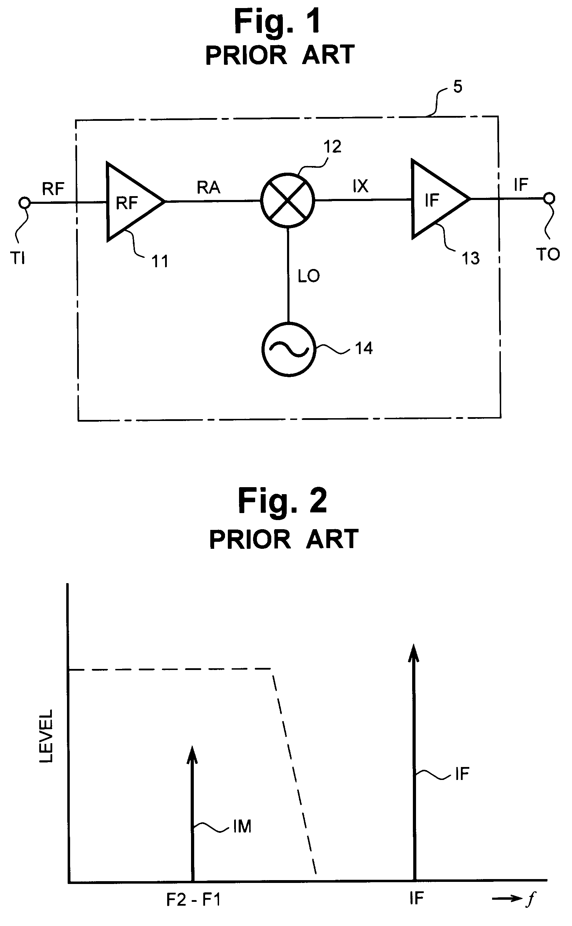

A configuration of a typical conventional front-end circuit for a receiver of a first kind is shown by a block diagram of Fig. 1. This conventional front-end circuit for receiver of the first kind is formed on a single semiconductor chip (IC) 5 and is constituted by a radio frequency amplifier 11 which amplifies a radio frequency (RF) signal supplied through a terminal TI and outputs an RF amplified signal RA, a mixer circuit 12 which, on receiving a supply of the RF amplified signal RA and a local oscillating signal (LO), carries out frequency conversion and produces a mixer intermediate frequency (IF) signal IX, an IF amplifier 13 which amplifies the mixer IF signal IX and outputs the IF signal through an output terminal TO, and a local oscillation circuit 14 which produces the local signal LO supplied to the mixer circuit 12.

Next, the operation of the conventional front-end circuit for receiver of the first kind described above is explained with reference to Fig. 1. The RF amplifier 11 amplifies the RF signal supplied through the input terminal TI and supplies it to the mixer circuit 12 as the RF amplified signal RA of a desired signal level. The mixer circuit 12 produces the mixer IF signal IX by frequency converting the supplied RF amplified signal RA in response to the supply of the local signal LO. The IF amplifier 13 amplifies the inputted mixer IF signal IX up to a desired signal level and outputs the amplified signal as the IF signal through the output terminal TO.

The IM distortion characteristics mentioned above have a dependency on the non-linear characteristics of the RF amplifier, the mixer circuit and the IF amplifier that constitute the front-end circuit of this kind, and are influenced by such multi-channel characteristics as an input signal level and other adjacent-channel signal levels.

However, in the front-end circuit for the receiver of the first kind, it is normal that, in order to secure the low noise-factor and the high gain frequency-conversion characteristics, the gain of each of the RF amplifier 11, the mixer circuit 12 and the IF amplifier 13 is made as high as possible. Thus, a problem is that, because of the influence from changes in the input signal levels and environmental changes, for example, temperature changes, the IM distortion characteristics of the IF output signal are subject to deterioration.

Where the above circuit is applied to, for example, a digital cordless telephone which is recently in use as a mobile communication system, since the RF frequency is 1.9 GHz, the channel separation is 25 kHz, and the frequency of the local signal LO is 1.65 GHz, it follows that the frequency of the IF signal is 250 MHz. The mixer IF signal IX of this 250 MHz is supplied to the IF amplifier 13. The IF amplifier 13 has band-pass characteristics with a prescribed width having its center frequency at the IF frequency 250 MHz, amplifies only the IF signal component, and outputs the amplified IF signal.

Now, the generation of the distorted signal is explained with reference to Fig. 2 which shows spectrum of the IF signal containing the distorted signal IM. First, it is assumed that, within the band pass region of the RF amplifier circuit 11, there exist a desired signal RF, and two interference waves F1 and F2 which are of extremely high levels and which are separated from each other by the same distance as the channel separation of 25 kHz. In this case, in the first conventional receiver front-end circuit, because of the non-linear characteristics of the RF amplifier 11, the mixer circuit 12 or the IF amplifier 13, higher harmonic signals of the signals RF, F1 and F2 are respectively produced so that the level of the desired signal RF is greatly suppressed, and an interference signal component is produced within the desired signal channel band or in the vicinity thereof so that there occurs a deterioration of signal quality in terms of cross-talks or an extreme deterioration of the S/N. Also, the output of the above IF amplifier 13 contains a distorted signal IM of 25 kHz or an integer number times of 25 kHz which is the frequency of the difference between the frequencies of the two interference waves F1 and F2.

A conventional radio receiving device containing a front-end circuit of a receiver of a second kind in which an improvement is attempted on the above explained IM distorted characteristics and which is disclosed in Japanese Patent Application Kokai Publication No. Hei 1-265725 is shown in Fig. 3. In the device shown, in addition to the RF amplifier 11 and the local oscillation circuit 14 which are the same as those in the first conventional front-end circuit, there are provided a mixer circuit 12A in which the conversion gain is variable in response to the supplied currents, an IF level detector 23 which detects the level of the IF signal and a variable current source which, in response to the IF level detected signal, adjusts the current supplied to the mixer circuit 12A. In this arrangement, the current supplied to the mixer circuit 12A or to the overall front-end circuit is caused to be increased when the level of the output signal of the mixer circuit 12A exceeds a predetermined level, whereby the occurrence of the IM distortion is suppressed with the noise factor or the frequency conversion gain being sacrificed.

Similarly, in a third conventional radio receiving device containing a front-end circuit of a receiver, which attempts to improve the IM distortion characteristics and which is disclosed in Japanese Patent Application Kokai Publication No. Hei 4-37317, the unnecessary wave component resulting from the IM distortion extracted by the mixer circuit, etc. is amplified and rectified and, by using the resulting signal for controlling the gain of the RF amplifier, the IM distortion is suppressed. Therefore, it is seen that no measure has been taken against the IF amplifier.

Further, in a fourth conventional radio transmitting and receiving device containing a front-end circuit of a receiver, which attempts to improve the IM distortion characteristics and which is disclosed in Japanese Patent Application Kokai Publication No. Hei 2-51913, the level of the beat signal corresponding to the IM distortion is detected from the second IF signal and, by using this detected signal, the gain control of the RF amplifier is carried out. Therefore, it is seen that no measure has been taken against the IF amplifier.

Each of the receiver front-end circuits of the third and fourth conventional examples explained above is configured by a discrete circuit so that suppression of the IM distortion for the overall receiving device is taken by externally carrying out the detection of the interference signal corresponding to the IM distortion component and the generating and processing of the necessary control signal. This arrangement requires a large scale circuit such as a beat signal detection circuit or a control signal generating circuit, which hinders the integrated circuits.

In the first conventional receiver front-end circuit described above, since it lacks the function of intermodulation (IM) distortion suppression, there is a defect that it is not possible to avoid the occurrence of the IM distortion caused by an increase in interference signal levels among frequencies of high input signal levels or adjacent channels which are positioned close to each other.

Also, in the second conventional receiver front-end circuit which has attempted to overcome the above defect, the output intermediate frequency (IF) signal level is detected and the control signal for the IM distortion suppression is generated. In this arrangement, the current supply to the circuits to be controlled is such that the control is not necessarily responsive to the amount of the IM distortion component but the control is made even when there is only a desired signal. Thus, a defect is that, where the IM distortion is not present, there inevitably occurs an increase in the noise factor or a deterioration of frequency conversion characteristics.

Further, in the conventional third and fourth receiver front-end circuit, the IM distortion suppression measure to the overall receiving device is taken by externally carrying out the detection of the interference signal corresponding to the IM distortion component and the generation of the necessary control signal. This arrangement requires a large scale circuit as a circuit for detecting unnecessary signals and a circuit for generating control signals, and this presents difficulties in forming the device in a single IC.

### SUMMARY OF THE INVENTION

An object of the present invention, therefore, is to overcome the problems existing in the prior art, and to provide a receiver front-end circuit which is in an integrated form and which improves intermodulation distortion characteristics of an output IF signal.

According to one aspect of the invention, there is provided a receiver front-end circuit which has, on a single semiconductor chip, at least a radio frequency amplifier circuit, a mixer circuit, and an intermediate frequency amplifier circuit, and in which at least one of the radio frequency amplifier circuit and the intermediate frequency amplifier circuit is gain-controlled in response to supply of a gain control signal, the receiver front-end circuit comprising:
a low pass filter which is disposed on the semiconductor chip and which filters an intermediate output signal supplied by the intermediate frequency amplifier circuit and extracts a distorted signal corresponding to an intermodulation distortion component contained in the intermediate frequency signal;
a peak level detection circuit which detects and generates a peak level signal of the distorted signal; and
a gain control circuit which generates the gain control signal in response to a supply of the peak level signal.

In the receiver front-end circuit according to the invention, the gain of the RF amplifier and the IF amplifier is decreased responsive to the level of the input interference signal waves, the IM distortion component included in the IF signal is greatly decreased, and the extent of the suppression of the desired IF signal level is reduced, thereby providing the device in the IC form having the excellent IM distortion suppression characteristics that enhance the quality of the output IF signals.

### BRIEF DESCRIPTION OF THE DRAWINGS

The above and other objects, features and advantages of the present invention will be apparent from the following description of preferred embodiments of the invention explained with reference to the accompanying drawings, in which:
Fig. 1 is a block diagram of a first conventional receiver front-end circuit;
Fig. 2 is a graph for use in explaining a spectrum relationship between IF signals and distortion signals in the first conventional receiver front-end circuit;

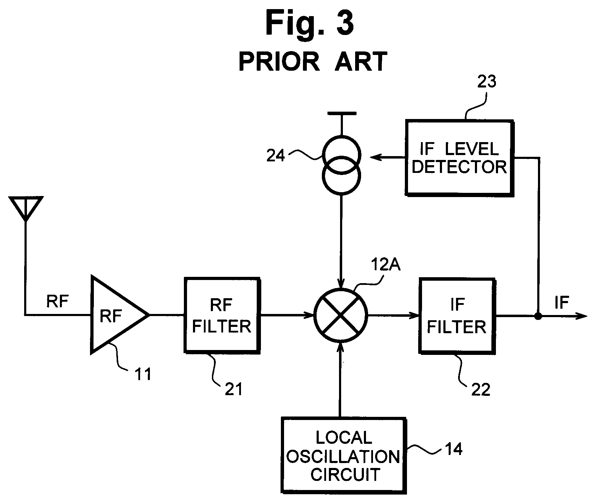

Fig. 3 is a block diagram of a second conventional receiver front-end circuit;
Fig. 4 is a block diagram of a receiver front-end circuit of a first embodiment according to the invention;
Fig. 5 is a block diagram of a receiver front-end circuit of a second embodiment according to the invention;
Fig. 6A is a block diagram of a receiver front-end circuit of a third embodiment according to the invention, and Fig. 6B is a circuit diagram of an active filter used in the circuit of this third embodiment according to the invention; and
Fig. 7 is a block diagram of a receiver front-end circuit of a fourth embodiment according to the invention.

### PREFERRED EMBODIMENTS OF THE INVENTION

Now, preferred embodiments of the invention are explained with reference to the drawings.

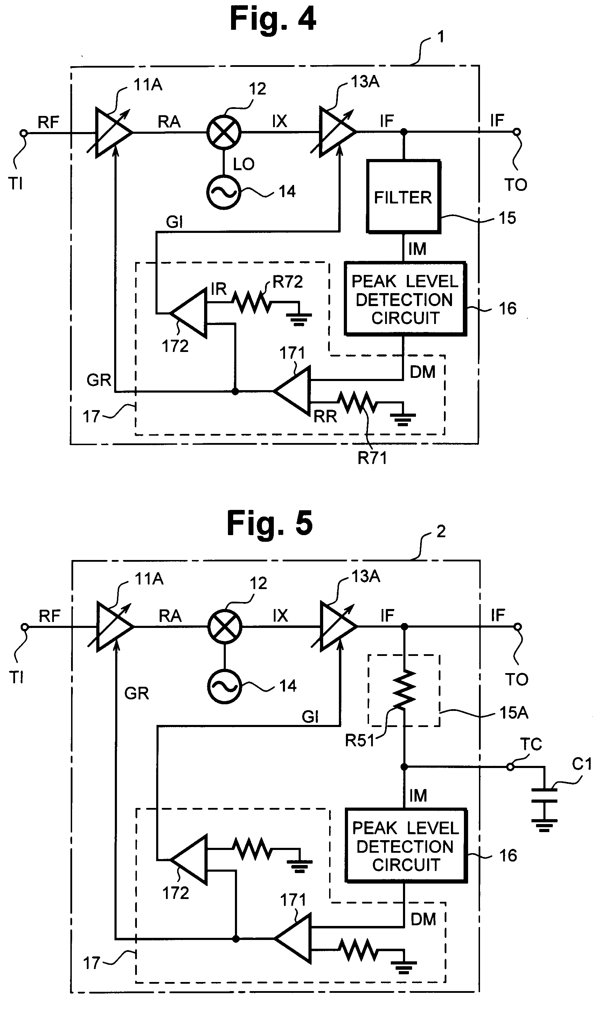

A first embodiment of the invention applied to a digital cordless receiver of the same kind as the prior art described above is explained with reference to the block diagram given in Fig. 4. In the explanation, the same reference numerals and symbols are used for the same or similar elements shown in Fig. 1. As shown in Fig. 4, the receiver front-end circuit of this embodiment is formed as a semiconductor integrated circuit (IC) on a single semiconductor chip as in the prior art, and includes the same mixer circuit 12 and local oscillation circuit 14 as in the prior art, and an RF amplifier 11A and an IF amplifier 13A which are the same as those in the prior art except that these amplifiers are capable of being gain-controlled. In addition to the above components, the front-end circuit further comprises a filter 15 which is a low-pass filter for extracting a distorted signal IM corresponding to a low region IM distortion component from the IF signal, a peak level detection circuit 16 which detects a peak level of the distorted signal IM and outputs a DC distorted voltage signal DM, and a gain control circuit 17 which generates gain control signals GR and GI respectively for the RF amplifier 11A and the IF amplifier 13A in response to the supply of the distorted voltage signal DM.

The gain control circuit 17 has resistors R71 and R72 which respectively set the reference voltage levels and is provided with operational amplifiers 171 and 172 which generate the signals GR and GI.

Next, the operation of the circuit of the first embodiment is explained with reference to Fig. 4. First, as is the same in the prior art, the RF amplifier 11A amplifies the RF signal supplied through an input terminal TI, and generates an RF amplified signal RA of a desired signal level. The signal RA is supplied to the mixer circuit 12 and, by using the local signal LO, the mixer circuit 12 carries out the frequency conversion of the signal RA and outputs the mixer IF signal IX. The mixer IF signal IX is supplied to the IF amplifier 13A. The IF amplifier 13A has band-pass characteristics of a predetermined width with the IF frequency 250 MHz being the center thereof, and amplifies only the IF signal component and outputs the IF signal. The IF signal is outputted to the outside as an output signal from an output terminal TO and is supplied to the filter 15. The filter 15 extracts from the inputted IF signal a distorted signal IM corresponding to the IM distortion component.

The distorted signal IM is made up of a frequency of 25 kHz or an integer number times of 25 kHz which corresponds to the channel separation of the digital cordless telephone as described with reference to the prior art. Thus, the filter 15 for extracting the distorted signal IM passes each of the components of the basic waves and the second harmonic waves that occupy majority of the energy so that the cutoff frequency is set to about 50 kHz. This filter 15 may be configured by a simple RC filter or LC filter. Therefore, the filter 15 can easily be formed within the IC 1.

Next, the distorted signal IM outputted from the filter 15 is supplied to the peak level detection circuit 16 which detects the DC voltage corresponding to the peak level of the distorted signal IM and outputs the detected signal DM. This peak level detection circuit 16 can be formed easily by such a circuit as a rectifying circuit using a well known diode bridge or a rectifying circuit using a diode and a resistor. The detected signal DM is supplied to the operational amplifier 171 of the gain control circuit 17. When the level of the detected signal DM has exceeded the reference voltage RR set by the resistor R71, the operational amplifier 171 generates the gain control signal GR that causes the gain of the RF amplifier 11A to be decreased. This gain control operation is continued until the detection signal DM becomes smaller than the reference voltage RR (DM < RR). This control signal GR is supplied to the RF amplifier as a gain control signal and is inputted as an input signal to the operational amplifier 172 of the next stage. When the input signal GR has exceeded the reference voltage RI set by the resistor R72, the operational amplifier 172 generates the gain control signal GI for decreasing the gain of the IF amplifier 13A. That is, as control sequences, first the control of the RF amplifier 11A is carried out and then the IF amplifier 13A is controlled. Therefore, the reference voltage IR of the operational amplifier 172 is appropriately set such that the output signal RA of the RF amplifier 11A is made sufficiently small in its level by the gain control signal GR, so that the control signal GI is generated before the mixer circuit 12 generates the IM distorted signal as a consequence that the output signal RA has exceeded an optimum operation range.

Where there is no interference waves inputted in the receiver front-end circuit of the embodiment, there is no distorted signal IM extracted by the filter 15, so that the gain of the RF amplifier 11A and IF amplifier 13A remains as a maximum gain without being reduced. In this case, the noise factor is also lowest with the sensitivity being in the best state.

Next, where the interference waves are present as explained above, the gain of the RF amplifier 11A and IF amplifier 13A is correspondingly reduced with a result that the IM distortion component contained in the IF signal is greatly reduced and the extent of the suppression of the desired IF signal level becomes small whereby the quality of the output IF signal is enhanced. This enables the enhancement of the functions required in the IC for use as the receiver front-end circuit and the enhancement of the output signal characteristics.

Where the IF signal input level is, for example, -19 dBm, the IM distortion level in the embodiment is suppressed to below -45 to -50 dB whereas the generation of the IM distortion in the prior art is on the order of -20 dB.

Next, a second embodiment of the invention is explained with reference to Fig. 5 wherein the same reference numerals and symbols are used for the same or similar elements shown in Fig. 4. The difference in the receiver front-end circuit IC 2 in this embodiment as compared with the IC 1 in the first embodiment is that, instead of the filter 15, there is a filter 15A which has only a resistor R51 that is one of the constituent elements of the RC type low-pass filter and a capacitor that is the other of the constituent elements is provided externally of the IC.

In the case where the entire filter 15 for the distorted signal extraction is provided within the IC 1 in the first embodiment, there is a problem to be solved. That is, in such a case, since the low-pass characteristics are fixed, a predetermined capacitance is formed within the IC 1 during the MOS fabrication process, and this capacitance is required to be formed with precision (for example, precision in the film thickness of SiO₂ or polysilicon).

In this second embodiment, the filter 15A is formed such that the resistor R51 which is an element constituting the filter is formed within the IC 2, and the capacitor C1 is formed outside the IC 2 with the terminal TC interposed. Further, instead of the resistor R51, the inductance may be formed and the filter 15A may be made an LC filter without departing from the spirit of the invention.

In this second embodiment, since the capacitor C1 which is an element of the filter 15A is externally provided, the value of the capacitance can be freely selected and, accordingly, the low-pass characteristics can be freely selected. Also, since this configuration does not require use of such a passive element, among the elements within the IC, as a capacitor whose capacitance value is determined by the film thickness which is especially difficult to control, it is possible to ensure the enhancement of the production yield and the required characteristics of the IC.

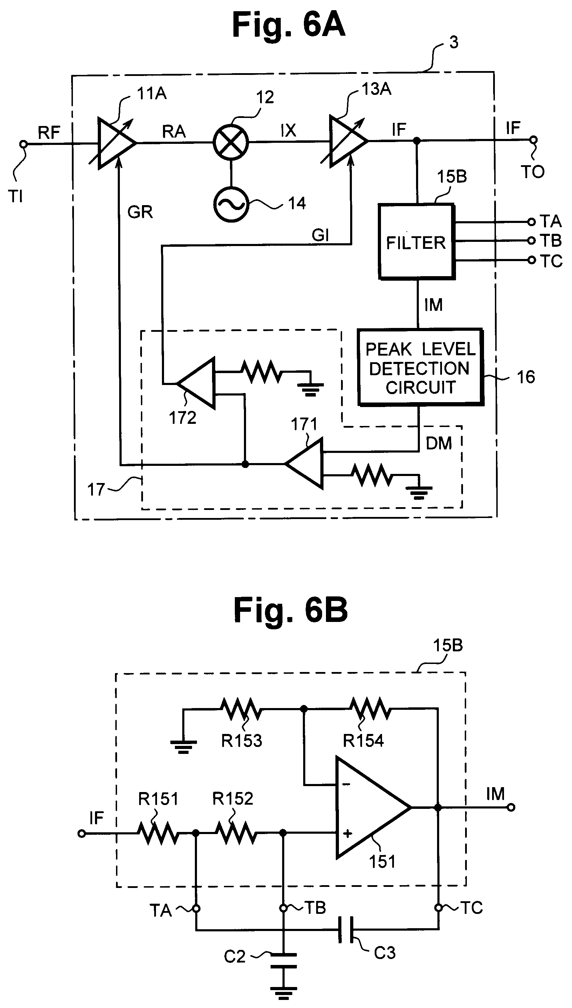

Next, a third embodiment of the invention is explained with reference to Fig. 6A wherein the same reference numerals and symbols are used for the same or similar elements shown in Fig. 4. The difference in the receiver front-end circuit IC 3 in this embodiment as compared with the corresponding circuit IC 1 in the first embodiment is that an active type filter 15B as shown in Fig. 6B is provided instead of a simple RC or LC type low-pass type filter 15.

As noted from Fig. 6B, the filter 15B is a secondary active low-pass filter which has a known lead-lag band-pass filter configuration and which comprises an operational amplifier 151, resistors R151 - R154, and terminals TA, TB, TC. Capacitors C2 and C3 are externally connected to the terminals TA, TB and TC.

In the first embodiment, the distortion extracting filter 15 was a simple RC or LC filter, in which case there was a limit in sharpening the cutoff characteristics in the attenuation region. Thus, there was a likelihood that an unnecessary IF signal component was contained in the extracted distorted signal.

However, in this third embodiment, the filter 15B is constituted by an active type filter with which the sharpening of the desired cutoff characteristics can easily be achieved. Thus, it is possible to extract the distorted signal in which the unnecessary IF signal component is effectively removed so that the IM distortion suppression characteristics can be greatly enhanced.

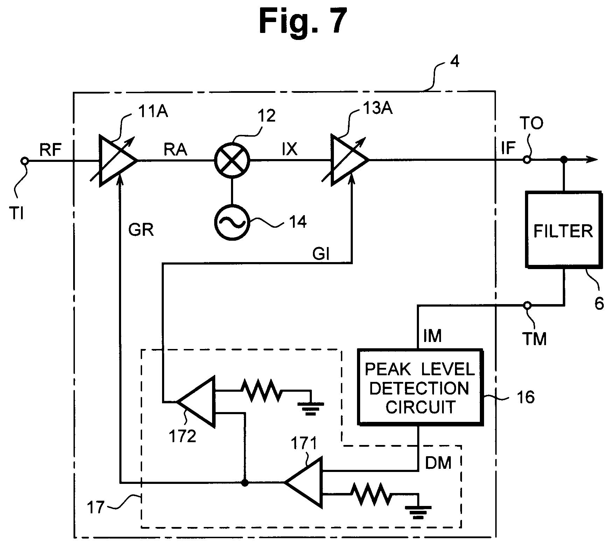

Next, a fourth embodiment of the invention is explained with reference to Fig. 7 wherein the same reference numerals and symbols are used for the same or similar elements shown in Fig. 4. The difference in the receiver front-end circuit IC 4 in this embodiment as compared with the corresponding circuit IC 1 in the first embodiment is that, instead of the internal filter 15, a filter 6 which functions the same as the filter 15 is externally provided outside the IC 4. The distorted signal that has been extracted by the filter 6 is supplied to the peak level detection circuit 16 through the terminal TM.

In this fourth embodiment, since it is configured that the low-pass filter for extracting the distorted signal is provided outside the IC 4 and only the extracted distorted signal is inputted, the frequency band and low pass characteristics can be comparatively freely set, which enables the circuit according to this embodiment to be adapted to a wider range of applications.

While the invention has been described in its preferred embodiments, it is to be understood that the words which have been used are words of description rather than limitation and that changes within the purview of the appended claims may be made without departing from the true scope of the invention as defined by the claims.

## Claims

1. A receiver front-end circuit which has, on a single semiconductor chip, at least a radio frequency amplifier circuit (11A), a mixer circuit (12), and an intermediate frequency amplifier circuit (13A), and in which at least one of said radio frequency amplifier circuit and said intermediate frequency amplifier circuit is gain-controlled in response to supply of a gain control signal, said receiver front-end circuit characterized by comprising:
a low-pass filter (15) which is disposed on said semiconductor chip and which filters an intermediate output signal supplied by said intermediate frequency amplifier circuit and extracts a distorted signal corresponding to an intermodulation distortion component contained in said intermediate frequency signal;
a peak level detection circuit (16) which detects and generates a peak level signal of said distorted signal; and
a gain control circuit (17) which generates said gain control signal in response to a supply of said peak level signal.

2. The receiver front-end circuit according to claim 1, in which said low-pass filter is a filter (15) of one of an RC type and an LC type provided with a capacitor formed by one of a resistor and a coil on said semiconductor chip.

3. The receiver front-end circuit according to claim 1, in which said low-pass filter is an active type filter (15B) having an operational amplifier and a plurality of resistors and capacitors.

4. The receiver front-end circuit according to claim 1, in which said low-pass filter comprises one of a resistor and a coil formed on said semiconductor chip and a capacitor (C1) provided externally of said semiconductor chip.

5. The receiver front-end circuit according to claim 1, in which said peak level detection circuit is provided with a rectifier having a diode formed on said semiconductor chip.

6. A receiver front-end circuit which has, on a single semiconductor chip, at least a radio frequency amplifier circuit, a mixer circuit, and an intermediate frequency amplifier circuit, and in which at least one of said radio frequency amplifier circuit and said intermediate frequency amplifier circuit is gain-controlled in response to supply of a gain control signal, said receiver front-end circuit characterized by comprising:
a low-pass filter (6) which is disposed externally of said semiconductor chip and which filters an intermediate output signal supplied by said intermediate frequency amplifier circuit and extracts a distorted signal corresponding to an intermodulation distortion component contained in said intermediate frequency signal;
a peak level detection circuit (16) which detects and generates a peak level signal of said distorted signal; and
a gain control circuit (17) which generates said gain control signal in response to a supply of said peak level signal.

7. The receiver front-end circuit according to claim 1, in which said gain control circuit (17) comprises:
a first and a second resistor (R71,R72) each having a first end and a second end which is grounded;
a first operational amplifier (171) having a first input terminal connected to the first end of said first resistor, a second input terminal for receiving said peak level signal from said peak level detection circuit (16), and an output terminal for outputting said gain control signal for said radio frequency amplifier circuit (11A); and
a second operational amplifier (172) having a first input terminal connected to the output terminal of said first operational amplifier, a second input terminal connected to the first end of said second resistor (R72), and an output terminal for outputting said gain control signal for said intermediate frequency amplifier circuit (13A).
